# EUROPÄISCHE PATENTSCHRIFT

(11) **EP 2 359 388 B1**
(45) Veröffentlichungstag und Bekanntmachung des Hinweises auf die Patenterteilung: **31.07.2013**
(21) Anmeldenummer: 09756295.3
(22) Anmeldetag: 13.11.2009
(51) Int. Cl.: C23C 16/24, H01L 21/67, C23C 16/27

(54) **VORRICHTUNG UND VERFAHREN ZUM BESCHICHTEN EINES SUBSTRATS MITTELS CVD**
DEVICE AND METHOD FOR COATING A SUBSTRATE USING CVD
DISPOSITIF ET PROCÉDÉ DE REVÊTEMENT D UN SUBSTRAT AU MOYEN DE CVD

(30) Priorität: 24.11.2008 DE 102008044025
(43) Veröffentlichungstag der Anmeldung: 24.08.2011
(73) Patentinhaber: DIACCON GmbH, 90762 Fürth (DE); CemeCon AG, 52146 Würselen (DE)
(72) Erfinder: RÜFFER, Martin, 92224 Amberg (DE); ROSIWAL, Stefan, 96049 Bamberg (DE); BAREISS, Christian, 52070 Aachen (DE); REICHERT, Walter, 52064 Aachen (DE); LEMMER, Oliver, 52066 Aachen (DE); PERLE, Marc, 91301 Forchheim (DE)
(74) Vertreter: Gassner, Wolfgang
(86) Internationale Anmeldenummer: PCT/EP2009/065177
(87) Internationale Veröffentlichungsnummer: WO 2010/057837

(56) Entgegenhaltungen:
- EP-A1- 0 714 997
- WO-A1-2008/003275
- US-A- 4 958 592
- US-A- 5 997 650
- US-B1- 6 582 780

## Beschreibung

Die Erfindung betrifft eine Vorrichtung nach dem Oberbegriff des Anspruchs 1 sowie ein Verfahren unter Verwendung der Vorrichtung.

Eine solche Vorrichtung ist aus der JP 01072992 A bekannt. Dabei sind die Heizleiter waagerecht oberhalb des zu beschichtenden Substrats angeordnet. Zur Erzeugung einer geeigneten Spannkraft sind die Heizleiter über eine Umlenkeinrichtung geführt und an ihrem einen Ende mit einem Gewicht versehen. Die nach dem Stand der Technik bekannte Vorrichtung hat den Nachteil, dass die Heizleiter bereits nach ein oder zwei Beschichtungsvorgängen brechen und infolgedessen unbrauchbar werden. Es ist in der Praxis notwendig, die Heizleiter nach jedem Beschichtungsvorgang auszutauschen. Das erfordert einen hohen Zeit- und Kostenaufwand.

Die US 5 997650 A beschreibt ein Heizleiterarray, welches eine Kraftregelung umfasst.

Zur Behebung des vorgenannten Nachteils ist es zwar denkbar, relativ dicke Heizleiter mit einem Durchmesser von etwa 2 mm zu verwenden. Die Verwendung solcher relativ dicken Heizleiter ist aber ebenfalls nachteilig. Dicke Heizleiter erzeugen im Gegensatz zu dünnen Heizleitern eine relativ große Wärmestrahlung, welche unerwünschterweise auf die Substrate einwirkt. Abgesehen davon wird zum Beheizen dicker Heizdrähte eine erheblich höhere elektrische Leistung benötigt.

Aufgabe der Erfindung ist es, die Nachteile nach dem Stand der Technik zu beseitigen. Es soll insbesondere eine Vorrichtung angegeben werden, welche ein mehrfaches Beschichten von Substraten ohne einen Austausch der Heizleiter ermöglicht. Nach einem weiteren Ziel der Erfindung soll dabei die eingesetzte elektrische Leistung möglichst gering sein. Eine weitere Aufgabe der Erfindung ist die Angabe eines möglichst effizienten Verfahrens zur Beschichtung eines Substrats mittels CVD.

Diese Aufgabe wird durch die Merkmale der Ansprüche 1 und 14 gelöst. Zweckmäßige Ausgestaltungen der Erfindung ergeben sich aus den Merkmalen der Ansprüche 2 bis 13 und 15.

Nach Maßgabe der Erfindung ist vorgesehen, dass die Spanneinrichtung einen ein Spanngewicht aufweisenden Schwenkarm umfasst, an dessen einem Ende der Heizleiter angebracht und dessen anderes Ende im Wesentlichen um eine horizontale Achse schwenkbar gelagert ist. - Damit gelingt es überraschenderweise, auch bei der Verwendung dünner Heizleiter deren Haltbarkeit drastisch zu erhöhen. Indem das Spanngewicht erfindungsgemäß über einen Schwenkarm auf dem Heizleiter aufgebracht wird, wirkt eine damit erzeugte Spannkraft im Wesentlichen in Richtung der Längserstreckung des Heizleiters. Thermisch bedingte Längenänderungen des Heizleiters beim Aufheizen oder Abkühlen werden durch ein Verschwenken des Schwenkarms kompensiert. Die vorgeschlagene Vorrichtung ist robust, langlebig und zuverlässig. - Die erfindungsgemäße Vorrichtung gewährleistet, dass die Heizleiter stets straff und exakt, insbesondere exakt parallel, gehalten werden. Auch nach einer Vielzahl von Betriebszyklen hängen die Heizleiter nicht durch. Deren Abstand zum beschichtenden Substrat kann über eine Vielzahl von Beschichtungsvorgängen hinweg stets reproduzierbar konstant gehalten.

Das Spanngewicht kann durch das Gewicht des Schwenkarms selbst zur Verfügung gestellt werden. In einem besonders einfachen Fall kann es sich bei dem Schwenkarm um ein in Spannrichtung schräg stehendes Flachmetall handeln.

Nach einer vorteilhaften Ausgestaltung der Erfindung ist das Spanngewicht zumindest zum Teil durch einen vom Schwenkarm sich erstreckenden Hebelarm gebildet. Üblicherweise reicht das Gewicht des Hebelarms bei einer geeigneten Anordnung desselben bereits aus, um eine ausreichende Spannkraft zu erzeugen. Selbstverständlich kann es auch sein, dass am Hebelarm noch zusätzlich ein Gewicht angebracht ist.

Zweckmäßigerweise erstreckt sich der Hebelarm vom zweiten Ende des Schwenkarms. In diesem Fall befindet sich ein Schwerpunkt der Spanneinrichtung in der Nähe des zweiten Endes des Schwenkarms und damit in der Nähe der horizontalen Achse. Damit kann auf einfache Weise eine stabile Anordnung der Spanneinrichtung durch einfaches Aufsetzen auf eine geeignet ausgestaltete Unterlage erreicht werden.

Zweckmäßigerweise ist der Schwenkarm aus einem elektrisch leitfähigen Metall hergestellt. Das zweite Ende des Schwenkarms kann an der zweiten Elektrode angebracht oder abgestützt sein. Eine elektrische Verbindung zwischen dem Heizleiter und der zweiten Elektrode kann zweckmäßigerweise ausschließlich über den Schwenkarm hergestellt werden. Mit der vorgeschlagenen Ausgestaltung kann vorteilhafterweise auf eine separate elektrische Verbindung zwischen dem Heizleiter und der zweiten Elektrode verzichtet werden.

Nach einer besonders einfachen Ausgestaltung der Erfindung ist das zweite Ende des Schwenkarms gegen ein an der zweiten Elektrode vorgesehenes Widerlager schwenkbar abgestützt. Beim Widerlager kann es sich um eine Stufe, eine Nut, eine Rinne oder dgl. handeln. Bei dieser besonders einfachen Ausgestaltung kann beispielsweise auf das Vorsehen eines Scharniers zur Verbindung des Schwenkarms mit einer Unterlage, insbesondere mit der zweiten Elektrode, verzichtet werden.

Nach einer weiteren Ausgestaltung sind zwei benachbarte Heizleiter aus einem einzigen Draht gebildet, dessen beide Enden an einem entweder am Schwenkarm oder an der ersten Elektrode vorgesehenen weiteren Schwenkarm gehalten sind. Dabei sind die beiden Enden des Drahts beiderseits einer Schwenkachse des weiteren Schwenkarms angebracht. Damit ist es möglich, beide nebeneinanderliegenden Heizdrähte gleichzeitig gespannt zu halten.

Nach einer weiteren Ausgestaltung sind die Heizleiter aus einem Refraktärmetall, vorzugsweise aus W, Ta, Mo, Rh oder einer Legierung davon, hergestellt. Die vorgeschlagenen Materialien eignen sich einerseits zur Herstellung besonders dünner Drähte und können andererseits hohen thermischen Belastungen ausgesetzt werden.

Die Heizleiter sind zweckmäßigerweise Drähte mit einem Durchmesser im Bereich von 5 µm bis 600 µm, vorzugsweise im Bereich von 100 µm bis 400 µm. Insbesondere bei Verwendung von Heizleitern mit einem kleinen Durchmesser kann die erforderliche elektrische Leistung zur Beschichtung eines Substrats erheblich reduziert werden. Gleichzeitig kann eine hohe Temperatur des Heizleiters erreicht werden, wodurch die Bildung atomaren Wasserstoffs unterstützt wird.

Die Heizleiter müssen nicht unbedingt in Form von Drähten ausgestaltet sein. Es kann auch sein, dass es sich dabei um Bänder, Stangen oder Bleche handelt. Ein Durchmesser oder eine Querschnittsfläche der Heizleiter muss nicht über deren gesamte Längserstreckung gleich sein.

Nach einer weiteren Ausgestaltung ist an der ersten Elektrode eine Halteeinrichtung zur Befestigung des anderen Endes des Heizleiters vorgesehen. Dabei kann es sich zweckmäßigerweise um eine Einrichtung zur klemmenden Befestigung des Heizleiters handeln. Die Halteeinrichtung kann insbesondere so ausgebildet sein, dass eine Befestigung der Heizleiter ohne eine wesentliche Umbiegung derselben möglich ist.

Nach einer weiteren Ausgestaltung der Erfindung ist die erste und/oder zweite Elektrode aus einem dispersionsverfestigten Kupferwerkstoff hergestellt. Der vorgeschlagene dispersionsverfestigte Kupferwerkstoff ist auch bei hohen Temperaturen äußerst formstabil. Abgesehen davon können Werkstücke, insbesondere Profile oder Hohlprofile, aus einem solchen Werkstoff einfach und kostengünstig extrudiert und nachfolgend bearbeitet werden.

Vorteilhafterweise ist eine Kühleinrichtung zum Kühlen der ersten und/oder zweiten Elektrode vorgesehen. Zu diesem Zweck können die erste und/oder zweite Elektrode beispielsweise in Form eines Hohlprofils ausgebildet sein, welches mit einem Kühlfluid durchströmt wird. Bei dem Kühlfluid handelt es sich zweckmäßigerweise um Wasser.

Nach einer weiteren vorteilhaften Ausgestaltung ist das Heizleiter-Array als Modul ausgeführt. D. h. die erste und die zweite Elektrode sind relativ zueinander, beispielsweise mittels einer Platte, fest verbunden und bilden eine Baueinheit. Eine solche Baueinheit ist zweckmäßigerweise so ausgeführt, dass sie in einem herkömmlichen Gehäuse einer CVD-Beschichtungsvorrichtung angeordnet werden kann.

Nach weiterer Maßgabe der Erfindung ist ein Verfahren zum Beschichten eines Substrats mittels CVD, insbesondere zum Beschichten mit Diamant oder Silizium vorgesehen, wobei unter Verwendung der erfindungsgemäßen Vorrichtung die folgenden Schritte durchgeführt werden:
Evakuieren des Gehäuses;
Erzeugen einer Wasserstoff und einen gasförmigen Kohlenstoffträger enthaltenden reaktiven Gasatmosphäre im Gehäuse;
Aufheizen der Heizleiter von Umgebungstemperatur auf eine Temperatur im Bereich von 1500°C bis 2800°C für eine Haltezeit von 1 bis 100 Stunden;
Evakuieren des Gehäuses;
Abkühlen der Heizleiter auf Umgebungstemperatur.

Beim Evakuieren des Gehäuses wird darin ein Druck im Bereich von etwa 0,1 bis 400 mbar eingestellt. Der Druck beim Erzeugen der reaktiven Gasatmosphäre beträgt 1 bis 400 mbar, vorzugsweise 3 bis 20 mbar. Die reaktive Gasatmosphäre enthält zweckmäßigerweise 90 bis 99,5 Gew.% an Wasserstoff. Zur Herstellung einer Diamantschicht kann als Kohlenstoffträger beispielsweise Methan in einer Konzentration von 0,5 bis 10 Gew.% verwendet werden. Zur Herstellung einer Siliziumschicht kann die reaktive Gasatmosphäre anstelle des gasförmigen Kohlenstoffträgers einen gasförmigen Siliziumträger enthalten. Optional kann die reaktive Gasatmosphäre zusätzlich Stickstoff, Sauerstoff, Phosphor oder borhaltige Gase enthalten.

Die Heizleiter werden zweckmäßigerweise auf eine Temperatur im Bereich von 1800°C bis 2500°C, vorzugsweise 1900°C bis 2300°C, aufgeheizt. Insbesondere bei den angegeben hohen Temperaturen wird eine Graphitabscheidung auf den Heizleitern aus der Gasphase vermieden. Damit wird gewährleistet, dass insbesondere auch bei hohen Konzentrationen des Kohlenstoffträgers in der Gasphase stets die Erzeugung von atomarem Wasserstoff an den Heizleitern aufrechterhalten bleibt. - Das Abkühlen der Heizleiter auf Umgebungstemperatur findet zweckmäßigerweise im Vakuum statt, d. h. nicht in der reaktiven Gasatmosphäre. Nach dem Abkühlen der Heizleiter auf Umgebungstemperatur wird das Gehäuse belüftet. Nachfolgend werden die beschichteten Substrate entnommen.

Wegen der weiteren Ausgestaltungsmerkmale des Verfahrens wird auf die bereits zur Vorrichtung beschriebenen Merkmale verwiesen, welche sinngemäß auch für das Verfahren angewendet werden können.

Unter Verwendung des erfindungsgemäßen Verfahrens ist es möglich, bis zu 50 Beschichtungsvorgänge nacheinander durchzuführen, ohne dass die Heizleiter ausgewechselt werden müssen. Dabei bleiben die Heizleiter vorteilhafterweise stets gespannt.

Nachfolgend werden Ausführungsbeispiele der Erfindung anhand der Zeichnungen näher erläutert. Es zeigen:
- Fig. 1: eine schematische Ansicht einer ersten Vorrichtung,
- Fig. 2: eine schematische Ansicht einer zweiten Vorrichtung,
- Fig. 3: die Kräfteverteilung bei einer Spanneinrichtung gemäß der Fig. 1 und 2 und
- Fig. 4: eine schematische Schnittansicht einer CVD-Beschichtungsvorrichtung.

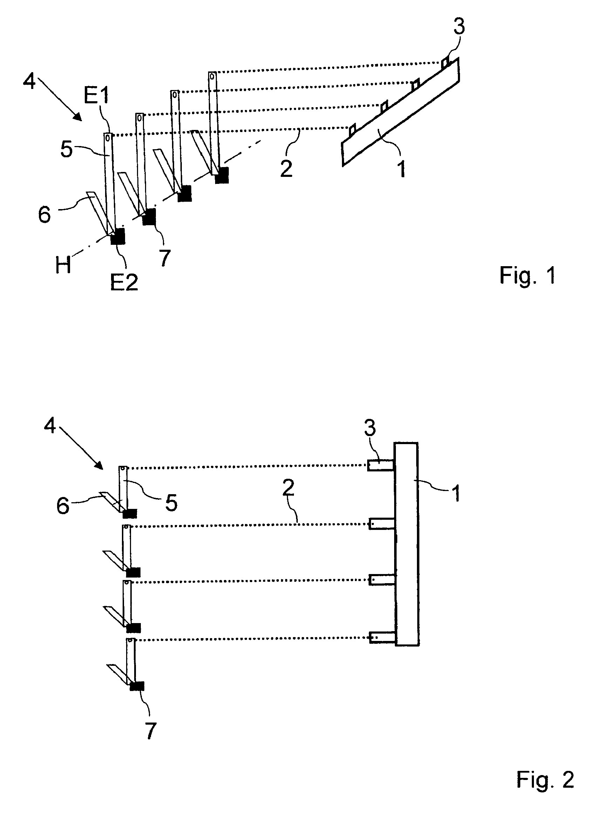

Fig. 1 zeigt eine schematische Ansicht einer ersten Vorrichtung. An einer ersten Elektrode 1 sind in einer Reihe nebeneinander, vorzugsweise mit etwa demselben Abstand, mehrere Heizleiter 2 angebracht. Die Heizleiter 2 können in Haltevorrichtungen 3 klemmend aufgenommen sein, welche an der ersten Elektrode 1 vorgesehen sind. Die Heizleiter 2 werden durch an deren Ende vorgesehene Spannelemente 4 individuell gespannt gehalten. Jedes der Spannelemente 4 weist einen Schwenkarm 5 auf, der um eine horizontale Achse H schwenkbar ist. An einem ersten Ende E1 jedes Spannelements 4 ist ein Ende eines Heizleiters 2 angebracht. Von einem zweiten Ende E2 erstreckt sich in eine von der ersten Elektrode 1 abgewandte Richtung ein Hebelarm 6. Der Schwenkarm 5 und der damit fest, z. B. mittels Schweißen, verbundene Hebelarm 6 bilden einen spitzen Winkel, vorzugsweise im Bereich von 20 bis 60°. - Durch die Gewichtskraft des Hebelarms 6 wird ein Kippmoment auf den Schwenkarm 5 ausgeübt, welches diesen in eine Richtung weg von der ersten Elektrode 1 zwingt. Damit wird auf den Heizleiter 2 eine Spannkraft ausgeübt. Der Heizleiter 2 wird geradlinig gespannt zwischen der ersten Elektrode 1 und dem ersten Ende E1 des Spannelements 4 gehalten. Es kann damit vorteilhafterweise auf einen Schleifkontakt oder ein besonderes, mit dem Heizleiter 2 verbundenes Stromversorgungskabel verzichtet werden. Bei der in Fig. 1 gezeigten ersten Vorrichtung sind die Heizleiter 2 in einer im Wesentlichen horizontal verlaufenden Ebene nebeneinander angeordnet.

Mit dem Bezugszeichen 7 ist ein Widerlager bezeichnet, in welchem das Spannelement 4 schwenkbar gehalten ist. Das Widerlager 7 kann in einem einfachen Fall aus einer Stufe gebildet sein, gegen welche das zweite Ende E2 des Spannelements 4 abgestützt ist. Das Widerlager 7 kann beispielsweise Bestandteil einer zweiten Elektrode sein. Bei einer elektrisch leitfähigen Ausbildung der Spannelemente 4 kann somit auf einfache Weise eine elektrische Verbindung zwischen dem Heizleiter 2 und der zweiten Elektrode hergestellt werden. In diesem Fall bildet die Spanneinrichtung einen Bestandteil der zweiten Elektrode 8, welcher relativ zur ersten Elektrode 1 zum Spannen des Heizleiters 2 bewegbar ist. D. h. in diesem Fall wird der Heizleiter 2 durch die relativ zueinander bewegbaren Elektroden 1, 8 geradlinig gespannt gehalten. Es kann somit auf eine unerwünschte Umbiegung des Heizleiters 2, welche etwa durch einen Schleifkontakt an einer Elektrode 1, 8 oder eine Umlenkeinrichtung bedingt sein kann, vermieden.

Bei der in Fig. 2 gezeigten Vorrichtung ist die erste Elektrode 1 etwa vertikal angeordnet. Zum Spannen der Heizleiter 2 sind wiederum Spannelemente 4 vorgesehen, welche hier allerdings in einer vertikalen Richtung übereinander angeordnet sind.

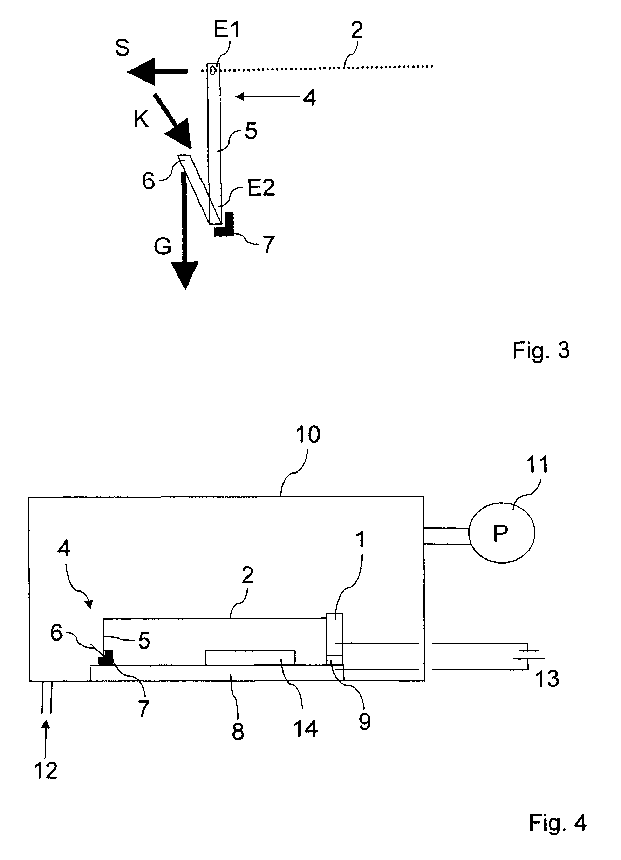

Fig. 3 zeigt schematisch die Kräfteverteilung am Spannelement 4. Ein mittels des Spannelements 4 gespannt gehaltener Heizleiter 2 erstreckt sich zwischen der ersten Elektrode 1 (hier nicht gezeigt) und dem ersten Ende E1 des Spannelements 4. Die Richtung des Heizleiters 2 wird im Weiteren als "Längserstreckung" bezeichnet. Durch die Wirkung der durch den Hebelarm 6 hervorgerufenen Gewichtskraft G, deren Vektor vertikal gerichtet ist, wird auf den Schwenkarm 5 ein Kippmoment ausgeübt, welches eine Spannkraft S bewirkt. Der Vektor der Spannkraft S verläuft parallel zur Längserstreckung des Heizleiters 2. Mit dem Bezugszeichen K ist eine Kontaktkraft bezeichnet, welche schräg in Richtung des Widerlagers 7 wirkt.

Fig. 4 zeigt eine schematische Schnittansicht einer CVD-Beschichtungsvorrichtung. Dabei sind die Widerlager 7 an einer in Form einer horizontalen Platte ausgestalteten zweiten Elektrode 8 angebracht. Die erste Elektrode 1 ist mit der zweiten Elektrode 8 unter Zwischenschaltung eines elektrischen Isolators 9 verbunden. Damit ist insgesamt ein kompaktes Heizleiter-Array gebildet, welches als Modul ausgestaltet ist. Mit dem Bezugszeichen 10 ist ein gasdichtes Gehäuse bezeichnet, welches das Heizleiter-Array umgibt. Indem insbesondere die erste 1 und die zweite Elektrode 8 innerhalb des Gehäuses 10 sich befinden, kann vorteilhafterweise eine Stromzuführung zur Versorgung der Elektroden 1, 8 einfach ausgestaltet werden. Die Stromzuführung muss insbesondere nicht bewegbar relativ zu einer Wand des Gehäuses 10 ausgestaltet sein.

Zum Evakuieren des Gehäuses 10 ist eine Pumpe 11 vorgesehen. Mit dem Bezugszeichen 12 ist ein Stutzen bezeichnet, durch den wahlweise Reaktionsgas in das Gehäuse 10 geführt werden kann. Die erste 1 und die zweite Elektrode 8 sind zum Beheizen der Heizleiter 2 mit einer Stromquelle 13 verbunden. Mit dem Bezugszeichen 14 ist ein Substrat bezeichnet, welches zum Beschichten auf der zweiten Elektrode 8 abgestützt ist.

### Bezugszeichenliste

- 1: erste Elektrode
- 2: Heizleiter
- 3: Halteeinrichtung
- 4: Spannelement
- 5: Schwenkarm
- 6: Hebelarm
- 7: Widerlager
- 8: zweite Elektrode
- 9: elektrischer Isolator
- 10: Gehäuse
- 11: Pumpe
- 12: Stutzen
- 13: Stromquelle
- 14: Substrat

- G: Gewichtskraft
- H: horizontale Achse
- K: Kontaktkraft
- S: Spannkraft

## Patentansprüche

1. Vorrichtung zum Beschichten eines Substrats (14) mittels CVD, insbesondere zum Beschichten mit Diamant oder Silizium,
wobei in einem Gehäuse (10) ein Heizleiter-Array aus einer Vielzahl langgestreckter, in einer im Wesentlichen horizontal verlaufenden Ebene nebeneinander angeordneter, mit einer ersten (1) und einer zweiten Elektrode (8) elektrisch verbundenen Heizleitern (2) vorgesehen ist, wobei
jeder Heizleiter (2) durch eine an dessen einem Ende angebrachte Spanneinrichtung individuell gespannt gehalten wird, **dadurch gekennzeichnet,**
**dass** die Spanneinrichtung einen ein Spanngewicht (G) aufweisenden Schwenkarm (5) umfasst, an dessen erstem Ende (E1) der Heizleiter (2) angebracht und dessen zweites Ende (E2) im wesentlichen um eine horizontale Achse (H) schwenkbar gelagert ist.

2. Vorrichtung nach Anspruch 1, wobei das Spanngewicht (G) zumindest zum Teil durch einen vom Schwenkarm (5) sich erstreckenden Hebelarm (6) gebildet ist.

3. Vorrichtung nach einem der vorhergehenden Ansprüche, wobei der Hebelarm (6) sich vom zweiten Ende (E2) des Schwenkarms (5) erstreckt.

4. Vorrichtung nach einem der vorhergehenden Ansprüche, wobei zumindest der Schwenkarm (5) aus einem elektrisch leitfähigen Metall hergestellt ist.

5. Vorrichtung nach einem der vorhergehenden Ansprüche, wobei das zweite Ende (E2) des Schwenkarms (5) an der zweiten Elektrode (8) angebracht oder abgestützt ist.

6. Vorrichtung nach einem der vorhergehenden Anspruche, wobei eine elektrische Verbindung zwischen dem Heizleiter (2) und der zweiten Elektrode (8) ausschließlich über den Schwenkarm (5) hergestellt wird.

7. Vorrichtung nach einem der vorhergehenden Ansprüche, wobei das zweite Ende (E2) des Schwenkarms (5) gegen ein an der zweiten Elektrode (8) vorgesehenes Widerlager (7) abgestützt ist.

8. Vorrichtung nach einem der vorhergehenden Ansprüche, wobei zwei benachbarte Heizleiter (2) aus einem einzigen Draht gebildet sind, dessen beide Enden an einem entweder am Schwenkarm (5) oder an der ersten Elektrode (1) vorgesehenen weiteren Schwenkarm gehalten sind.

9. Vorrichtung nach einem der vorhergehenden Ansprüche, wobei die Heizleiter (2) aus einem Refraktärmetall, vorzugsweise aus W, Ta, Mo, Rh oder einer Legierung davon, hergestellt sind.

10. Vorrichtung nach einem der vorhergehenden Ansprüche, wobei die Heizleiter (2) einen Durchmesser von 5 bis 600 µm, vorzugsweise von 100 bis 400 µm, aufweisen.

11. Vorrichtung nach einem der vorhergehenden Ansprüche, wobei die erste (1) und/oder zweite Elektrode (8) aus einem dispersionsverfestigten Kupferwerkstoff hergestellt ist.

12. Vorrichtung nach einem der vorhergehenden Ansprüche, wobei eine Kühleinrichtung zum Kühlen der ersten (1) und/oder zweiten Elektrode (8) vorgesehen ist.

13. Vorrichtung nach einem der vorhergehenden Ansprüche, wobei das Heizleiter-Array als Modul ausgeführt ist.

14. Verfahren zum Beschichten eines Substrats mittels CVD, insbesondere zum Beschichten mit Diamant oder Silizium, wobei unter Verwendung einer Vorrichtung nach einem der vorhergehenden Ansprüche die folgenden Schritte durchgeführt werden:
Evakuieren des Gehäuses (10);
Erzeugen einer Wasserstoff und einen gasförmigen Kohlenstoff- oder Siliziumträger enthaltenden reaktiven Gasatmosphäre im Gehäuse (10);
Aufheizen der Heizleiter (2) von Umgebungstemperatur auf eine Temperatur im Bereich von 1500°C bis 2800°C für eine Haltezeit von 1 bis 100 Stunden;
Evakuieren des Gehäuses (10);
Abkühlen der Heizleiter (2) auf Umgebungstemperatur.

15. verfahren nach Anspruch 14, wobei die reaktive Gasatmosphäre Bor und/oder Phosphor enthält.

## Claims

1. Device for coating a substrate (14) using CVD, in particular for coating with diamond or silicon,
wherein in a housing (10) a heating conductor array composed of a plurality of heating conductors (2) which are electrically connected with a first (1) and a second electrode (8) and which are longitudinally extended and arranged next to each other in an essentially horizontal plane is provided, wherein
each heating conductor (2) is individually held taut by a tension unit mounted on its one end,
**characterized in that**
the tension unit comprises a swivel arm (5) having a tension weight (G), the heating conductor (2) being mounted on the first end (E1) of the swivel arm (5) and the second end (E2) of the swivel arm (5) being mounted pivotably essentially around a horizontal axis (H).

2. Device as defined in claim 1, wherein the tension weight (G) is at least partially formed by a lever arm (6) extending from the swivel arm (5).

3. Device as defined in one of the preceding claims, wherein the lever arm (6) extends from the second end (E2) of the swivel arm (5).

4. Device as defined in one of the preceding claims, wherein at least the swivel arm (5) is made of an electrically conductive metal.

5. Device as defined in one of the preceding claims, wherein the second end (E2) of the swivel arm (5) is mounted or supported on the second electrode (8).

6. Device as defined in one of the preceding claims, wherein an electrical connection is made between the heating conductor (2) and the second electrode (8) exclusively via the swivel arm (5).

7. Device as defined in one of the preceding claims, wherein the second end (E2) of the swivel arm (5) is supported against an abutment (7) provided on the second electrode (8).

8. Device as defined in one of the preceding claims, wherein two adjacent heating conductors (2) are formed from a single wire whose both ends are held on a further swivel arm provided either on the swivel arm (5) or on the first electrode (1).

9. Device as defined in one of the preceding claims, wherein the heating conductors (2) are made of a refractory metal, preferably of W, Ta, Mo, Rh or an alloy thereof.

10. Device as defined in one of the preceding claims, wherein the heating conductors (2) have a diameter of 5 to 600 µm, preferably of 100 to 400 µm.

11. Device as defined in one of the preceding claims, wherein the first (1) and/or second electrode (8) is made of a dispersion-strengthened copper material.

12. Device as defined in one of the preceding claims, wherein a cooling unit is provided for cooling the first (1) and/or second electrode (8).

13. Device as defined in one of the preceding claims, wherein the heating conductor array is designed as a module.

14. Method for coating a substrate using CVD, in particular for coating with diamond or silicon, wherein the following steps are performed using a device as defined in one of the preceding claims:
Evacuation of the housing (10);
Generation of a reactive gaseous atmosphere containing hydrogen and a gaseous carbon or silicon carrier in the housing (10);
Heating the heating conductors (2) from the ambient temperature to a temperature ranging from 1500° C to 2800° C for a holding time of 1 to 100 hours;
Evacuation of the housing (10);
Cooling down the heating conductors (2) to the ambient temperature.

15. Method as defined in claim 14, wherein the reactive gaseous atmosphere contains boron and/or phosphorus.

## Revendications

1. Dispositif de revêtement d'un substrat au moyen de CVD, en particulier de revêtement avec du diamant ou du silicium,
où une matrice conductrice de chaleur réalisée à partir d'une pluralité de conducteurs de chaleur (2) s'étendant en longueur, disposés côte à côte dans un plan essentiellement horizontal, reliés électriquement à une première (1) et une seconde électrode (8) est prévue dans un boîtier (10), où
chaque conducteur de chaleur (2) est maintenu tendu individuellement par un dispositif de tension monté sur l'une de ses extrémités,
**caractérisé en ce que**
le dispositif de tension comprend un bras pivotant(5) présentant un poids tendeur (G), à la première extrémité duquel (E1) est monté le conducteur de chaleur (2) et dont la seconde extrémité (E2) est disposée de manière à pivoter essentiellement autour d'un axe horizontal (H).

2. Dispositif selon la revendication 1, où le poids tendeur (G) est constitué au moins en partie par un bras de levier (6) s'étendant à partir du bras pivotant (5).

3. Dispositif selon l'une des revendications précédentes, où le bras de levier (6) s'étend à partir de la seconde extrémité (E2) du bras pivotant (5).

4. Dispositif selon l'une des revendications précédentes, où au moins le bras pivotant (5) est réalisé en un métal électriquement conducteur.

5. Dispositif selon l'une des revendications précédentes, où la seconde extrémité (E2) du bras pivotant (5) est montée ou appuyée sur la seconde électrode (8).

6. Dispositif selon l'une des revendications précédentes, où une connexion électrique est réalisée entre le conducteur de chaleur (2) et la seconde électrode (8) uniquement par le biais du bras pivotant (5).

7. Dispositif selon l'une des revendications précédentes, où la seconde extrémité (E2) du bras pivotant (5) est appuyée contre une butée (7) prévue sur la seconde électrode (8).

8. Dispositif selon l'une des revendications précédentes, où deux conducteurs de chaleur (2) adjacents sont composés d'un seul et unique fil dont les deux extrémités sont maintenues sur un autre bras pivotant prévu soit sur le bras pivotant (5) ou sur la première électrode (1).

9. Dispositif selon l'une des revendications précédentes, où les conducteurs de chaleur (2) sont réalisés en un métal réfractaire, de préférence en W, Ta, Mo, Rh ou en un de leurs alliages.

10. Dispositif selon l'une des revendications précédentes, où les conducteurs de chaleur (2) présentent un diamètre compris entre 5 et 600 µm, de préférence compris entre 100 et 400 µm.

11. Dispositif selon l'une des revendications précédentes, où la première (1) et/ou la seconde électrode (8) est réalisée en un alliage de cuivre durci par dispersion.

12. Dispositif selon l'une des revendications précédentes, où un dispositif de refroidissement est prévu pour le refroidissement de la première (1) et/ou de la seconde électrode (8).

13. Dispositif selon l'une des revendications précédentes, où la matrice conductrice de chaleur est réalisée sous forme de module.

14. Procédé de revêtement d'un substrat au moyen de CVD, en particulier de revêtement avec du diamant ou du silicium, où les opérations suivantes sont effectuées en utilisant un dispositif selon l'une des revendications précédentes:
mise sous vide du boîtier (10);
production d'une atmosphère gazeuse réactive comprenant de l'hydrogène et un porteur de carbone gazeux ou de silicium dans le boîtier (10);
mise en température des conducteurs de chaleur (2) de la température ambiante à une température comprise entre 1500°C à 2800°C pour un temps de maintien de 1 à 100 heures;
mise sous vide du boîtier (10);
refroidissement des conducteurs de chaleur (2) à la température ambiante.

15. Procédé selon la revendication 14, où l'atmosphère gazeuse contient du bore et/ou du phosphore.
